# EUROPEAN PATENT APPLICATION

(11) **EP 4 545 691 A1**
(43) Date of publication of application: **30.04.2025**
(21) Application number: 24207314.6
(22) Date of filing: 17.10.2024
(51) Int. Cl.: C30B 23/02, C30B 29/36

(54) **SIC EPITAXIAL WAFER**

(30) Priority: 25.10.2023 JP 2023183151
(71) Applicant: Resonac Corporation, Tokyo 105-7325 (JP)
(72) Inventor: Nishihara, Yoshitaka, Tokyo, 105-7325 (JP)
(74) Representative: Strehl & Partner mbB

(57) **Abstract**

A SiC epitaxial wafer according to the present embodiment includes: a SiC substrate; and a SiC epitaxial layer deposited on the SiC substrate, wherein, in the SiC substrate, a density of basal plane dislocations is 1/cm² or more and 3000/cm² or less, and wherein, in the SiC epitaxial layer, a density of double Shockley (2SSF) type stacking faults is 4/cm² or more and 10/cm² or less, and a density of stacking faults other than the double Shockley (2SSF) type stacking faults is 2/cm² or less.

## Description

### BACKGROUND

### Field

The present disclosure relates to a SiC epitaxial wafer.

### Description of Related Art

Silicon carbide (SiC) has a dielectric breakdown field one order of magnitude larger and a band gap three times larger than silicon (Si). In addition, silicon carbide (SiC) has properties such as a thermal conductivity about three times higher than silicon (Si). For this reason, silicon carbide (SiC) is expected to be applied to power devices, high frequency devices, high temperature operating devices, and the like. For this reason, in recent years, SiC epitaxial wafers have come to be used for the above-described semiconductor devices.

A SiC epitaxial wafer is obtained by stacking a SiC epitaxial layer on the surface of a SiC substrate. Hereinafter, the substrate before the SiC epitaxial layer is stacked thereon is referred to as a SiC substrate, and the substrate after the SiC epitaxial layer is stacked thereon is referred to as a SiC epitaxial wafer. The SiC substrate is produced by being cut out from a SiC ingot. SiC devices such as power devices, high frequency devices, and high temperature operating devices are obtained by forming devices in a SiC epitaxial layer of a SiC epitaxial wafer and then cutting the SiC epitaxial wafer into chips.

Generally, the SiC epitaxial wafer contains inherent crystal defects. Some crystal defects adversely affect subsequent processes and hinder normal operation of the SiC devices. Such defects are called killer defects. For example, it is known that basal plane dislocations (BPDs) cause stacking faults which are one type of killer defect (see, for example, Patent Document 1).

In addition, Patent Document 2 discloses a case in which there are a plurality of types of stacking faults and a method for reducing the total number of stacking faults and double Shockley type stacking faults among them.

### [Patent Documents]

[Patent Document 1] Japanese Patent No. 5961357
[Patent Document 2] Japanese Patent No. 6824088

### SUMMARY

As described above, it is important to check the position and number of basal plane dislocations (BPDs), which cause killer defects, when producing SiC devices. However, it is difficult to nondestructively check the position at which many basal plane dislocations are concentrated and the number of basal plane dislocations in a SiC substrate after a SiC epitaxial layer is stacked.

The present disclosure has been made in consideration of the above problems, and an object of the present disclosure is to provide a SiC epitaxial wafer in which it possible to estimate a position at which many basal plane dislocations are concentrated and the number of basal plane dislocations in a SiC substrate even after a SiC epitaxial layer is stacked.
(1) A SiC epitaxial wafer according to a first aspect includes: a SiC substrate; and a SiC epitaxial layer deposited on the SiC substrate. In the SiC substrate, a density of basal plane dislocations is 1/cm² or more and 3000/cm² or less. In the SiC epitaxial layer, a density of double Shockley (2SSF) type stacking faults is 4/cm² or more and 10/cm² or less, and a density of stacking faults other than the double Shockley (2SSF) type stacking faults is 2/cm² or less.
(2) The SiC epitaxial wafer according to the above aspect may have a diameter of 145 mm or more.
(3) The SiC epitaxial wafer according to the above aspect may have a diameter of 195 mm or more.
(4) In the SiC epitaxial wafer according to the above aspect, the density of the double Shockley (2SSF) type stacking faults may be 6/cm² or more and 10/cm² or less.
(5) In the SiC epitaxial wafer according to the above aspect, the density of the double Shockley (2SSF) type stacking faults may be 8/cm² or more and 10/cm² or less.
(6) In the SiC epitaxial wafer according to the above aspect, the density of the double Shockley (2SSF) type stacking faults may be 4/cm² or more and 6/cm² or less.

In the SiC epitaxial wafer according to the above aspect, it possible to estimate the position at which many basal plane dislocations are concentrated and the number of basal plane dislocations in a SiC substrate even after a SiC epitaxial layer is stacked.

### BRIEF DESCRIPTION OF THE DRAWINGS

FIG. 1 is a cross-sectional view of a SiC epitaxial wafer according to the present embodiment.
FIG. 2 is a plan view of the SiC epitaxial wafer according to the present embodiment.

### DETAILED DESCRIPTION

Hereinafter, a SiC epitaxial wafer and the like according to the present embodiment will be described in detail with reference to the drawings as appropriate. In the drawings which will be used in the following description, featured portions may be enlarged for convenience in order to make the features of the present embodiment easy to understand, and the dimensional ratios of constituent elements may be different from the actual ones. The materials, dimensions, and the like which will be exemplified in the following description are examples, and the present disclosure is not limited thereto and can be carried out with appropriate modifications without changing the gist of the present disclosure.

In the present specification, an individual orientation is indicated by [ ] and a collective orientation is indicated by < >. For negative indices, a "-" (bar) is customarily placed above the number in crystallography, but in the present specification, a negative sign is placed before the number.

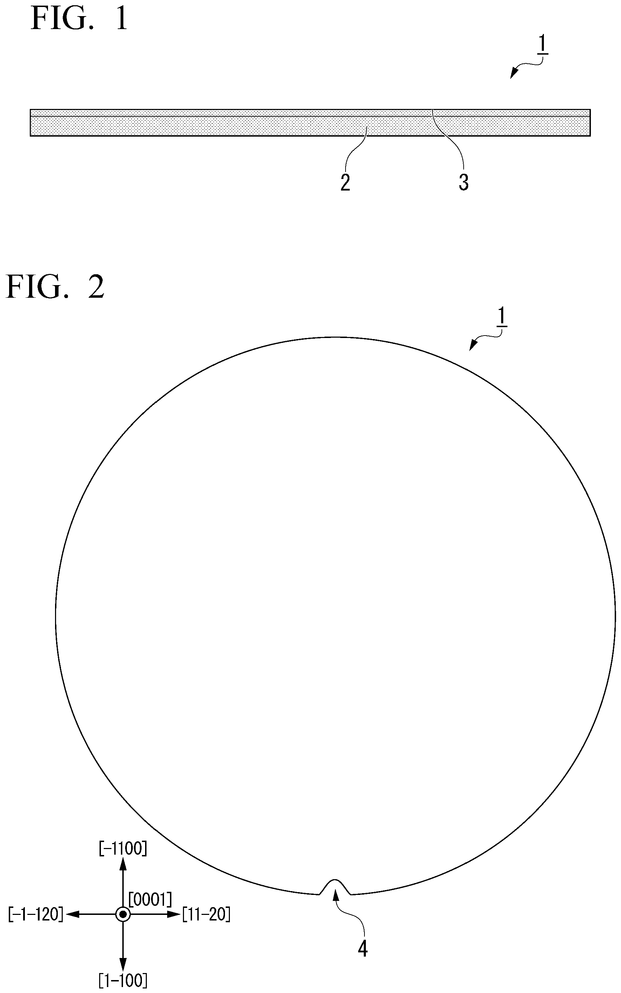

FIG. 1 is a cross-sectional view of a SiC epitaxial wafer 1 according to the present embodiment. FIG. 2 is a plan view of the SiC epitaxial wafer 1 according to the present embodiment.

The SiC epitaxial wafer 1 includes a SiC substrate 2 and a SiC epitaxial layer 3. The shape of the SiC epitaxial wafer 1 in a plan view is approximately circular. The SiC epitaxial wafer 1 may have a notch 4 for checking the direction of a crystal axis. In addition, the SiC substrate 2 may have an orientation flat instead of the notch 4.

The diameter of the SiC epitaxial wafer 1 is, for example, 145 mm or more, and preferably 149 mm or more. In addition, the diameter of the SiC epitaxial wafer 1 is preferably 155 mm or less, and more preferably 151 mm or less. In addition, the diameter of the SiC epitaxial wafer 1 may be, for example, 195 mm or more, and preferably 199 mm or more. In addition, the diameter of the SiC epitaxial wafer 1 is preferably 205 mm or less, and more preferably 201 mm or less.

The SiC substrate 2 is made of, for example, n-type SiC. The polytype of the SiC substrate 2 is not particularly limited and may be any of 2H, 3C, 4H, and 6H. The SiC substrate 2 is, for example, 4H-SiC.

In the SiC substrate 2, the density of basal plane dislocations (BPDs) is 1/cm² or more and 3000/cm² or less. When the basal plane dislocations in the SiC substrate 2 are taken over by the SiC epitaxial layer 3, stacking faults which are one type of killer defect may be caused. For this reason, it is ideal that there be no basal plane dislocations in the SiC substrate 2. However, it is difficult to stably produce a SiC substrate that does not have basal plane dislocations. In contrast, if the density of the basal plane dislocations is within a desired range, it is possible to relatively stably produce the SiC substrate 2. In other words, if the density of the basal plane dislocations is 1/cm² or more and 3000/cm² or less, it is possible to stably obtain the SiC substrate 2 while satisfying the required quality.

In the SiC epitaxial wafer 1 according to the present disclosure, it possible to estimate the position at which many basal plane dislocations are concentrated and the number of basal plane dislocations in a SiC substrate 2 after the SiC epitaxial layer 3 is stacked, and thus it is not necessary to constantly measure the density of the basal plane dislocations in the SiC substrate 2. In a case in which it becomes necessary to evaluate the density of the basal plane dislocations in the SiC substrate 2, it is possible to measure the density of the basal plane dislocations using a photoluminescence method, for example.

The SiC epitaxial layer 3 is stacked on one surface of the SiC substrate 2. In the SiC epitaxial layer 3, the density of double Shockley (2SSF) type stacking faults is 4/cm² or more and 10/cm² or less. The density of the double Shockley (2SSF) type stacking faults is more preferably 6/cm² or more and 10/cm² or less, further preferably 7/cm² or more and 10/cm² or less, and particularly preferably 8/cm² or more and 10/cm² or less. When the density range is within this range, it is easier to check the position at which many basal plane dislocations are concentrated (that is, the position at which the density of the basal plane dislocations is high) and the number of basal plane dislocations in the SiC substrate. In addition, the density of the double Shockley (2SSF) type stacking faults is preferably 4/cm² or more and 8/cm² or less, and more preferably 4/cm² or more and 6/cm² or less. When the density range is within this range, it is possible to curb occurrence of a device failure while checking the position at which many basal plane dislocations are concentrated (that is, the position at which the density of the basal plane dislocations is high) and the number of basal plane dislocations in the SiC substrate. The double Shockley (2SSF) type stacking faults are caused by the basal plane dislocations.

In addition, in the SiC epitaxial layer 3, the density of stacking faults other than the double Shockley (2SSF) type stacking faults is 2/cm² or less. The density of the stacking faults other than the double Shockley (2SSF) type stacking faults is preferably 1/cm² or less, and more preferably 0.5/cm² or less. As the density of the stacking faults other than the double Shockley (2SSF) type stacking faults is lower, it is possible to further reduce device failures due to stacking faults other than the double Shockley (2SSF) type stacking faults.

There are various types of stacking faults. The stacking faults include Frank type, Shockley type, and a mixed type of these. In addition, within each of the Frank type, the Shockley type, and the mixed type of these, the faults are further classified according to the number of layers in which the faults occur. Table 1 shows the classification of the stacking faults. Table 1 corresponds to Table 1 in Kamata et al., Appl. Phys. Lett. 97, 172107 (2010).

**[Table 1]**

| SF type | Name | Notation | PL emission at RT(at < 10K) |
|---|---|---|---|
| Frank type | Intrinsic | (5,0) | 488,(478,485,488,490) |
| | Multilayers | (4,2) | 457,(450,455,458,460) |
| | Extrinsic | (4,1) | 424,(415,419,423,425) |
| Shockley type | Double SSF | (6,2) | 500 |
| | (3,5)type | (5,3) | 480 |
| | 8H SiC | (4,4) | 455, (463,468,472,473) |
| | Single SSF | (3,1) | 420 |

The classification of the stacking faults can be specified through the following procedure. First, mapping of the stacking faults of the SiC epitaxial wafer 1 is measured using a photoluminescence method. The density of the stacking faults in the SiC epitaxial layer 3 is, for example, 4/cm² or more and 12/cm² or less. At this point in time, it is not possible to classify each of the stacking faults and it is not clear which type of stacking fault it is.

A spectral measurement is then performed on each of the mapped stacking faults. The spectral measurement is performed using MiPLATO manufactured by EtaMax Co., Ltd. In the spectrum measurement, light with an excitation wavelength of 355 nm is applied onto the SiC epitaxial layer 3, and a fluorescence wavelength generated from each of the stacking faults is measured. In the measurement of the fluorescence wavelength, the intensity of the light generated from each of the stacking faults is measured for each wavelength using a spectrometer, and a peak wavelength at which the light emission intensity is maximum is obtained. A band gap due to the stacking faults varies depending on the number of layers in which the faults occur in a stacking direction, and the peak wavelength of the light emitted from each of the stacking faults also varies depending on a difference in the band gap. For this reason, each of the stacking faults can be classified on the basis of the peak wavelength obtained through the spectral measurement.

In the double Shockley type stacking faults, the peak wavelength is 500 nm. The double Shockley type stacking faults are one type of killer defect, and it is ideal that there be no double Shockley type stacking faults. The double Shockley type stacking faults are caused by the basal plane dislocations in the SiC substrate 2. In a case in which the SiC substrate 2 has a certain number or more of basal plane dislocations, it is difficult to reduce the number of double Shockley type stacking faults to zero. Since the SiC substrate 2 in the present disclosure has a certain number or more of basal plane dislocations, the SiC epitaxial layer 3 has double Shockley type stacking faults caused by the basal plane dislocations.

The stacking faults other than the double Shockley type stacking faults are located at the positions at which the peak wavelength is a wavelength other than 500 nm. The stacking faults other than the double Shockley type stacking faults can also be killer defects. It is more preferable for there to be fewer of the stacking faults other than the double Shockley type stacking faults, and the density of the stacking faults is preferably 2/cm² or less. It is considered that the stacking faults other than the double Shockley type stacking faults are generated by causes other than basal plane dislocations.

The SiC epitaxial layer 3 of the SiC epitaxial wafer 1 according to the present embodiment has almost no stacking faults other than the double Shockley type stacking faults. For this reason, it can be assumed that most of the stacking faults checked after stacking the SiC epitaxial layer 3 are caused by the basal plane dislocations in the SiC substrate 2. For this reason, in the SiC epitaxial wafer 1 according to the present embodiment, it possible to estimate the position at which many basal plane dislocations are concentrated and the number of basal plane dislocations in the SiC substrate 2 by measuring the stacking faults that occur after deposition of the SiC epitaxial layer 3 by a photoluminescence method. In a case in which the SiC epitaxial layer 3 has many stacking faults other than the double Shockley type stacking faults, the accuracy of this estimation is reduced. However, since the SiC epitaxial layer 3 of the SiC epitaxial wafer 1 according to the present embodiment has almost no stacking faults other than the double Shockley type stacking faults, the estimation accuracy is high. Information on the density, positions, number, and the like of the basal plane dislocations in the SiC substrate 2 is important information for quality assurance of the SiC epitaxial wafer 1.

As described above, in the SiC epitaxial wafer 1 according to the present embodiment, it possible to nondestructively estimate the position at which many basal plane dislocations are concentrated and the number of basal plane dislocations in the SiC substrate 2 even after the SiC epitaxial layer 3 is stacked. For this reason, the SiC epitaxial wafer 1 according to the present embodiment is a SiC epitaxial wafer in which the quality of the SiC substrate 2 is assured and of which the reliability is high. In addition, in the position at which many basal plane dislocations are concentrated (that is, the position at which the density of the basal plane dislocations is high) in the SiC substrate 2, a device failure is highly likely to occur. In the SiC epitaxial wafer 1 according to the present embodiment, it is possible to check in advance the position of a portion at which a device failure is highly likely to occur.

Next, a method for manufacturing the SiC epitaxial wafer 1 according to the present embodiment will be described.

First, the SiC substrate 2 is prepared. A SiC substrate in which the density of the basal plane dislocations is 1/cm² or more and 3000/cm² or less is used as the SiC substrate 2. Although it is difficult to obtain or produce a SiC substrate with no basal plane dislocations, it is relatively easy to obtain the SiC substrate 2 having the basal plane dislocations within a predetermined range.

Next, the SiC epitaxial layer 3 is stacked on the SiC substrate 2. The SiC epitaxial layer 3 is deposited by, for example, a chemical vapor deposition method (a CVD method).

In the SiC epitaxial layer 3 according to the present embodiment, it is necessary to selectively control the density of certain faults among the stacking faults, and therefore more precise control is required compared to the case in which the density of all stacking faults is controlled. The crystal growth conditions that make the density of the certain faults among the stacking faults within a predetermined range may differ for each film deposition device, and therefore tuning is required in accordance with each film deposition device.

For this reason, first, as a pre-process, the growth conditions for the SiC epitaxial layer 3 are tuned. In the pre-process, the growth conditions for the SiC epitaxial layer 3 are determined in accordance with a specific film deposition device. This pre-process is carried out for each film deposition device. In addition, when the inside of the film deposition device is cleaned, the pre-process is carried out again. In the pre-process, adjustment film deposition is repeated a plurality of times until the growth conditions for the SiC epitaxial layer 3 are determined. In the pre-process, parameters of a temperature, a C/Si ratio, and a growth rate are changed in three stages of an initial stage, a middle stage, and a final stage of the crystal growth.

For example, if only the double Shockley type stacking faults are to be reduced, this reduction can be achieved by setting the C/Si ratio in the three stages of the initial stage, the middle stage, and the final stage of the crystal growth within a preferred range, as described in Patent Document 2. On the other hand, if the number of stacking faults other than the double Shockley type are to be reduced while keeping the number of double Shockley type stacking faults within a predetermined range, this reduction cannot be achieved with a simple setting on an optimum range. It is necessary to determine the conditions in the pre-process, taking into account the unique characteristics of each device.

First, in first adjustment film deposition, the SiC epitaxial layer 3 is deposited with the temperature, the C/Si ratio, and the growth rate in each of the three growth stages set as first conditions. After the first adjustment film deposition, the SiC epitaxial layer 3 is subjected to photoluminescence measurement to obtain the density of the certain stacking faults in the SiC epitaxial layer 3.

Next, in second adjustment film deposition, the SiC epitaxial layer 3 is deposited under second conditions obtained by changing at least one of the temperature, the C/Si ratio, and the growth rate in each of the three growth stages from the first conditions. After the second adjustment film deposition, the SiC epitaxial layer 3 is subjected to photoluminescence measurement to obtain the density of the certain stacking faults in the SiC epitaxial layer 3.

Then, the results of the first and second adjustment film depositions are feed back to determine the conditions for third adjustment film deposition. In the third adjustment film deposition, at least one of the temperature, the C/Si ratio, and the growth rate in each of the three growth stages is changed from the first and second conditions.

This adjustment film deposition and feedback of the measurement results are repeated to determine the final growth conditions for the SiC epitaxial layer 3. The repetition of the adjustment film deposition and the feedback of the measurement results are carried out by minutely changing the growth conditions, and the final growth conditions for the SiC epitaxial layer 3 are precisely determined in accordance with the unique characteristics of each film deposition device.

The temperature condition for the adjustment film deposition is changed within the range of 1500 °C or more and 1700 °C or less in each of the three growth stages. The temperature condition is finally tuned with a change width in the range of 1 °C.

The C/Si ratio of the adjustment film deposition is changed within the range of 0.8 or more and 1.5 or less in each of the three growth stages. The C/Si ratio is finally tuned with a change width in the range of 0.05. The C/Si ration is a ratio of a C source gas to a Si source gas on the growth surface of the SiC epitaxial layer 3.

The growth rate in the adjustment film deposition is changed in the range of 5 µm/h or more and 100 µm/h or less in each of the three growth stages. The growth rate is finally tuned with a change width in the range of 5 µm/h.

Next, the actual film deposition of the SiC epitaxial layer 3 is carried out under the film deposition conditions determined in the pre-process. Through these procedures, it is possible to produce the SiC epitaxial wafer 1 according to the present embodiment.

As described above, by determining the conditions taking into account the unique characteristics of each device and the like, it is possible to produce the SiC epitaxial wafer 1 according to the present embodiment. The SiC epitaxial wafer 1 according to the present embodiment has almost no stacking faults other than the double Shockley type stacking fault, and thus by specifying the double-Shockley type stacking faults, it is also possible to estimate the number of basal plane dislocations and the position at which many basal plane dislocations are concentrated in the SiC substrate 2. That is, in the SiC epitaxial wafer 1 according to the present embodiment, the quality of the SiC substrate 2 can be assured even after the SiC epitaxial layer 3 is stacked.

As described above, the preferable embodiments of the present disclosure have been described in detail, the present disclosure is not limited to specific embodiments, and various modifications and changes can be made within the scope of the gist of the present disclosure described in the claims.

### [Examples]

### "Example 1"

First, a SiC substrate 2 having a diameter of 150 mm was prepared. A SiC substrate in which the density of the basal plane dislocations is 1/cm² or more and 3000/cm² or less was selected to be used as the SiC substrate 2.

Next, a SiC epitaxial layer 3 was deposited on the SiC substrate 2. The growth conditions for the SiC epitaxial layer 3 were set in advance by repeating adjustment film deposition and feedback. Defects on the surface of the SiC epitaxial layer 3 were observed using a photoluminescence method. The density of stacking faults in the SiC epitaxial layer 3 was 5.33/cm². In addition, in the SiC epitaxial layer 3, the density of double Shockley type stacking faults due to basal plane dislocations was 4.05/cm². In addition, the density of the stacking faults other than the double Shockley type stacking faults was 1.29/cm². The density of the stacking faults, the density of the double Shockley type stacking faults caused by the basal plane dislocations, and the density of the stacking faults other than the double Shockley type stacking faults in the SiC epitaxial layer 3 are rounded values, and the density of the stacking faults and the sum of the density of the double Shockley type stacking faults and the density of the stacking faults other than double Shockley type stacking faults in the SiC epitaxial layer 3 are not necessarily equal to each other.

Next, the cross section of the SiC epitaxial wafer 1 at the position at which the stacking faults were checked was measured. In the SiC epitaxial wafer 1 of Example 1, most of the defects specified as the stacking faults were the double Shockley type stacking faults. In addition, many basal plane dislocations were checked in the SiC substrate 2 at the position at which the double Shockley type stacking faults were checked.

From the above, in the SiC epitaxial wafer 1 of Example 1, information on the basal plane dislocations in the SiC substrate 2 could be estimated from information on the stacking faults measured after the deposition of the SiC epitaxial layer 3.

### "Example 2"

In Example 2, a SiC epitaxial wafer 1 was produced under the same conditions as in Example 1. Then, defects on the surface of the SiC epitaxial layer 3 were observed using a photoluminescence method. The density of stacking faults in the SiC epitaxial layer 3 was 9.17/cm². In addition, in the SiC epitaxial layer 3, the density of double Shockley type stacking faults due to basal plane dislocations was 7.35/cm². In addition, the density of the stacking faults other than the double Shockley type stacking faults was 1.81/cm². In addition, the cross section of the SiC epitaxial wafer 1 at the position at which the stacking faults were checked was measured. In the SiC epitaxial wafer 1 of Example 2, most of the defects specified as the stacking faults were the double Shockley type stacking faults. In addition, many basal plane dislocations were checked in the SiC substrate 2 at the position at which the double Shockley type stacking faults were checked. In other words, information on the basal plane dislocations in the SiC substrate 2 could be estimated from information on the stacking faults measured after the deposition of the SiC epitaxial layer 3.

### "Comparative Example 1"

As in Example 1, a SiC substrate 2 having a diameter of 150 mm was prepared. A SiC substrate in which the density of the basal plane dislocations is 1/cm² or more and 3000/cm² or less was selected to be used as the SiC substrate 2.

Next, a SiC epitaxial layer 3 was deposited on the SiC substrate 2. The growth conditions for the SiC epitaxial layer 3 were different from those in Example 1. Defects on the surface of the SiC epitaxial layer 3 were observed using a photoluminescence method. The density of stacking faults in the SiC epitaxial layer 3 was 3.09/cm². In addition, in the SiC epitaxial layer 3, the density of double Shockley type stacking faults due to basal plane dislocations was 0.72/cm². In addition, the density of the stacking faults other than the double Shockley type stacking faults was 2.37/cm².

In the SiC epitaxial wafer of Comparative Example 1, the number of stacking faults other than the double Shockley type stacking faults was large, and it was not possible to estimate the basal plane dislocations in the SiC substrate 2 unless the stacking faults were classified one by one. In the SiC epitaxial wafer of Comparative Example 1, it took a long time to estimate the position at which many basal plane dislocations were concentrated and the number of basal plane dislocations. In addition, in the SiC epitaxial wafer of Comparative Example 1, the number of other stacking faults was large, and the accuracy of estimating the position at which the basal plane dislocations were concentrated and the number of basal plane dislocations was low.

The results for the SiC epitaxial wafer 1 using the SiC substrate 2 with a diameter of 150 mm have been shown so far, and a similar study was conducted for the SiC epitaxial wafer 1 using the SiC substrate 2 with a diameter of 200 mm. The same trend was observed in the case of 200 mm diameter as in the case of 150 mm diameter.

### EXPLANATION OF REFERENCES

1 SiC epitaxial wafer
2 SiC substrate
3 SiC epitaxial layer
4 Notch

## Claims

1. A SiC epitaxial wafer comprising:
a SiC substrate; and
a SiC epitaxial layer deposited on the SiC substrate,
wherein, in the SiC substrate, a density of basal plane dislocations is 1/cm² or more and 3000/cm² or less, and
wherein, in the SiC epitaxial layer, a density of double Shockley (2SSF) type stacking faults is 4/cm² or more and 10/cm² or less, and a density of stacking faults other than the double Shockley (2SSF) type stacking faults is 2/cm² or less.

2. The SiC epitaxial wafer according to claim 1, having a diameter of 145 mm or more.

3. The SiC epitaxial wafer according to claim 1 or 2, having a diameter of 195 mm or more.

4. The SiC epitaxial wafer according to any one of claims 1 to 3, wherein the density of the double Shockley (2SSF) type stacking faults is 6/cm² or more and 10/cm² or less.

5. The SiC epitaxial wafer according to any one of claims 1 to 4, wherein the density of the double Shockley (2SSF) type stacking faults is 8/cm² or more and 10/cm² or less.

6. The SiC epitaxial wafer according to any one of claims 1 to 3, wherein the density of the double Shockley (2SSF) type stacking faults is 4/cm² or more and 8/cm² or less.

7. The SiC epitaxial wafer according to any one of claims 1 to 3, wherein the density of the double Shockley (2SSF) type stacking faults is 4/cm² or more and 6/cm² or less.
